# EUROPEAN PATENT APPLICATION

(11) **EP 3 462 346 A1**
(43) Date of publication of application: **03.04.2019**
(21) Application number: 18196836.3
(22) Date of filing: 26.09.2018
(51) Int. Cl.: G06F 17/50, G06Q 10/06

(54) **DESIGN SUPPORT DEVICE AND DESIGN SUPPORT METHOD**

(30) Priority: 28.09.2017 JP 2017187680
(71) Applicant: Hitachi, Ltd., Tokyo 100-8280 (JP)
(72) Inventor: ITABAYASHI, Yuki, Tokyo, 100-8280 (JP); ONODERA, Makoto, Tokyo, 100-8280 (JP); KONGOU, Chikara, Tokyo, 100-8280 (JP); SHINTANI, Masaki, Tokyo, 100-8280 (JP); QI, He, Tokyo, 100-8280 (JP)
(74) Representative: MERH-IP Matias Erny Reichl Hoffmann Patentanwälte PartG mbB

(57) **Abstract**

A design support device supports a design project achieved by executing a plurality of tasks where one or a plurality of subtasks are included. The design support device includes a recording unit which sequentially stores design history data of a design performed by a designer using a calculator, an output unit which outputs design support information, and a calculation unit. The calculation unit includes a task relevance extraction unit which associates the design history data with the task to sequentially generate task-design history relevant data, a subtask definition unit which defines the subtask with respect to the task-design history relevant data to sequentially generate design process data, a subtask relevance extraction unit which generates subtask relevant data indicating a relevance between subtasks with respect to the plurality of pieces of design process data, and a difference extraction unit which estimates a subtask to be performed in a later design work with respect to an in-process design work from a difference between past design process data of a project performed in the past and in-process data in a project performed currently to obtain an estimate subtask, and calculates an optimal execution order to obtain estimate design process data. The estimate design process data is output through the output unit.

## Description

### BACKGROUND OF THE INVENTION

### Field of the Invention

The present invention relates to a technology of creating design/manufacturing data of a product, and particularly to a design support device and a design support method which detects an influence range according to a design process proposal and a change/improvement in specification of a product which is appropriate to an operator's request, and presents the influence range to a client in advance.

### Related Art

In recent years, the number of examination items to be considered in product development tends to increase as multi-functions and high performances are required for products. Therefore, in a product development field, a design method and a design support tool are employed as an organized effort in order to develop high quality products having less defects and reworking in a short period of time.

However, in an actual design, the number of redundant examination items is increased while establishing of a reviewing sequence and expanding of functions of the design support tool do not follow thereto. The design has been performed through trial and error day by day. As an effort against the problem, a checking work is automatically performed in part of design, and an improvement in work is employed step by step. However, there is trial and error for adjustment, a reviewing sequence is complicated, a reviewing content is also needed to satisfy several conditions with accuracy in some cases, and thus it takes a lot of time.

Regarding trial and error in design, there is known the following technique in which a man-hour of defects and risks are estimated in advance and presented to an operator.

JP-A-20TB598300 discloses a device which can estimate a man-hour of reworking caused by various large and small defects occurring in design stages and a cost necessary for solving the defects. In the disclosure, the device creates or updates a defect matrix in a unit of each project. A vertical axis of the defect matrix represents a procedure of finding defects, and a horizontal axis represents a procedure of mixing defects. Each column is written with the number of defects in reworking from the finding procedure to the mixing procedure. With this configuration, it is possible to easily estimate a cost necessary for the man-hour of reworking due to a defect and an improvement.

JP-A-2007-58409 discloses a device which estimates a situation of a current development project by estimating a potential risk on the basis of similarity to a project performed in the past, and presents a countermeasure. In the disclosure, the device automatically takes history data of the operator and compares the data with the problems and the history data of the similar type of phenomenon which has occurred in the past. The device presents a countermeasure against a risk of the project having a high similarity to characteristics and the current situation.

JP-A-20TB160546 discloses a device which estimates a potential risk and presents a countermeasure, and also presents a feasibility in the countermeasure of a risk in addition to the device disclosed in JP-A-2007-58409. In order to calculate the feasibility, attribute information related to a project such as an estimated cost, a prime cost, an estimated profit, a target profit margin, a client business, a cooperative company's name are input to an attribute information database. A relational equation is calculated to quantitatively obtain the feasibility.

### SUMMARY OF THE INVENTION

However, the above techniques have problems as follows.

In the techniques disclosed in JP-A-20TB598300, JP-A-2007-58409, and JP-A-20TB160546, the man-hour of defects, a potential risk, and a countermeasure are presented. However, it is difficult to visually confirm the presented risk and a specific influence range of the countermeasure.

In addition, in the techniques disclosed in JP-A-20TB598300 and JP-A-20TB160546, the defect matrix may be necessarily created for each project, and the operator may necessarily input data to an attribute information database. Therefore, a degree of perfection may depend on a feeling or an empirical value of the operator during adjustment or inputting. In some cases, defects and requirements are overlooked, and thus a defect may be caused.

According to the invention, there is provided a design support device which supports a design project achieved by executing a plurality of tasks where one or a plurality of subtasks are included.

The design support device includes a recording unit which sequentially stores design history data of a design performed by a designer using a calculator, an output unit which outputs design support information, and a calculation unit.

The calculation unit includes a task relevance extraction unit which associates the design history data with the task to sequentially generate task-design history relevant data, a subtask definition unit which defines the subtask with respect to the task-design history relevant data to sequentially generate design process data, a subtask relevance extraction unit which generates subtask relevant data indicating a relevance between subtasks with respect to the plurality of pieces of design process data, and a difference extraction unit which estimates a subtask to be performed in a later design work with respect to an in-process design work from a difference between past design process data of a project performed in the past and in-process data in a project performed currently to obtain an estimate subtask, and calculates an optimal execution order to obtain estimate design process data. The estimate design process data is output through the output unit.

In addition, according to the invention, there is provided a design support method which supports a design project achieved by executing a plurality of tasks where one or a plurality of subtasks are included.

The design support method includes storing sequentially design history data of a design performed by a designer using a calculator, associating the design history data with the task to sequentially generate task-design history relevant data, defining a subtask with respect to the task-design history relevant data to sequentially generate design process data, generating subtask relevance data which indicates a relevance between the subtasks with respect to the plurality of pieces of design process data, estimating a subtask to be performed in a later design work with respect to an in-progress design work from a difference between past design process data of a project performed in a past and in-process data in a project performed currently to obtain an estimate subtask, and presenting estimate design process data of which an optimal execution order is calculated to the designer as the estimate subtask.

In addition, according to the invention, there is provided a design support device which supports a design project achieved by executing a plurality of tasks where one or a plurality of subtasks are included.

The design support device includes a unit which stores the operation history of a design tool operated by an operator and a history of creating/referring a file as design history data, a unit which compares date information in the design history data with date information of a task in a design procedure table of each product or project, and associates and registers the task and the design history data as task-design history relevant data, a unit which divides the design history data in a unit of subtask on the basis of the task-design history relevant data, and associates and registers the subtasks and an execution order of the subtasks in a design process database as design process data, a unit which calculates a relevance of the subtask from a relation between a creation file and a reference file in the subtask and a relation between the subtask and the execution order and registers the relevance to the design process database as subtask relevance data, a unit which sets the created design process data as in-process data for an in-process design work, sets the design process data registered to the design process database as past design process data, compares the in-process data with the past design process data, estimates a subtask to be performed in a subsequent design work with respect to the in-process design work, registers the estimate subtask as the estimate subtask data, a unit which calculates an optimal execution order on the basis of an average man-hour of the estimate subtask and the subtask relevance data, and registers the optimal execution order as an estimate design process, and a unit which displays the estimate design process through an output device.

In addition, according to the invention, there is provided a design support method which supports an operator to perform a design project using a calculator, the project being achieved by executing a plurality of tasks where one or a plurality of subtasks are included.

The design support method includes analyzing a design history of the operator from the calculator in a unit of subtask by comparing the history with a design procedure table, calculating a relevance between subtasks from a relation between a creation file associated with the subtask and a reference file, extracting an optimal design process from the relevance, and presenting the optimal design process to the operator.

A correlation of a design process and a casual relation between processes are registered and accumulated, so that it is possible to detect an influence range in advance when a specification content of design is changed/improved. In addition, countermeasures for a risk are taken in advance, so that reworking is prevented and quality can be maintained.

### BRIEF DESCRIPTION OF THE DRAWINGS

FIG. 1 is a diagram illustrating an exemplary configuration of a design support device of the invention;
FIG. 2 is a diagram illustrating an example of a registration procedure from a recording unit to a design history database;
FIG. 3 is a diagram illustrating an example of a flow of obtaining design process data from a subtask definition unit;
FIG. 4 is a diagram illustrating an example of a registration procedure from a subtask relevance extraction unit to a design process;
FIG. 5 is a diagram illustrating an example of a procedure up to a design process update unit after a process of a difference extraction unit;
FIG. 6 is a diagram illustrating a specific example of design history data;
FIG. 7 is a diagram illustrating an example of task-design history relevant data;
FIG. 8 is a diagram illustrating an example of a subtask definition screen as a monitor screen of a calculator;
FIG. 9 is a diagram illustrating an exemplary expansion screen which displays basis data of a subtask proposal;
FIG. 10 is a diagram illustrating an example of the design process data which is generated from the subtask definition unit;
FIG. 11 is a diagram illustrating an example of subtask relevance data which is generated from the subtask relevance extraction unit;
FIG. 12 is a diagram illustrating an example of in-process data using a WBS structure;
FIG. 13 is a diagram illustrating an example of past design process data using the WBS structure;
FIG. 14 is a diagram illustrating an example of estimate subtask data which is generated from the difference extraction unit in a time line format;
FIG. 15 is a diagram illustrating an example of the estimate subtask data which is generated from the difference extraction unit in the time line format;
FIG. 16 is a diagram illustrating an example of output data of the design process update unit in the time line format; and
FIG. 17 is a diagram illustrating an example of output data of the design process update unit in the WBS structure.

### DESCRIPTION OF THE EMBODIMENTS

Hereinafter, examples of a design support device of the invention will be described using the drawings.

### [First Embodiment]

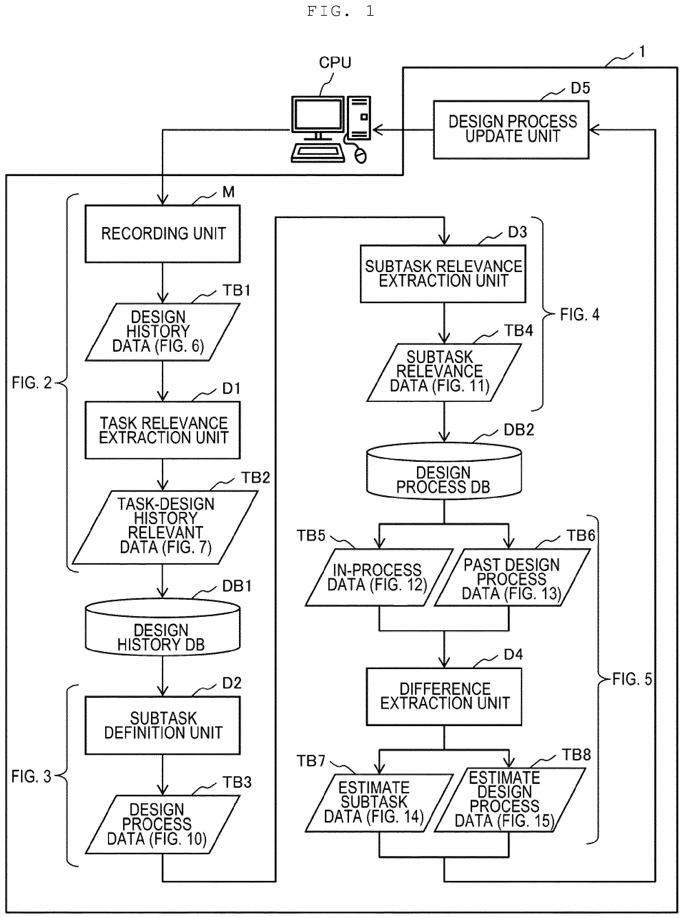

FIG. 1 is a diagram illustrating a configuration of an embodiment of the design support device according to the invention.

A CPU in FIG. 1 is a calculator such as a personal computer, and is configured by an input unit, an output unit including a display unit, and a calculation unit. Each operator engaged in design performs a design work with the calculator.

FIG. 1 illustrates a series of processing contents of a design support device 1 which supports the design work performed by the operator using the calculator. The design support device 1 in the drawing is indicated by a recording unit M, a processing unit D, a data table TB which is data generated by the processing unit D, and a database DB which stores data.

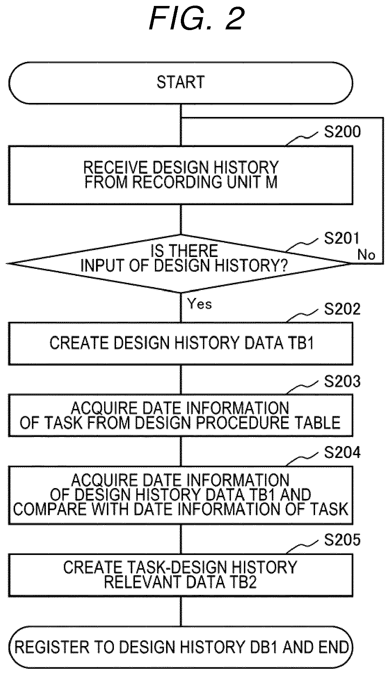

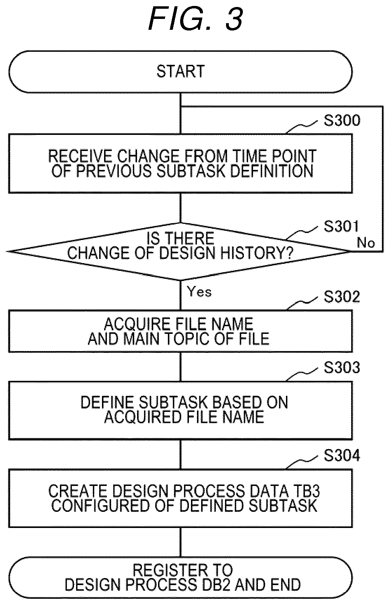

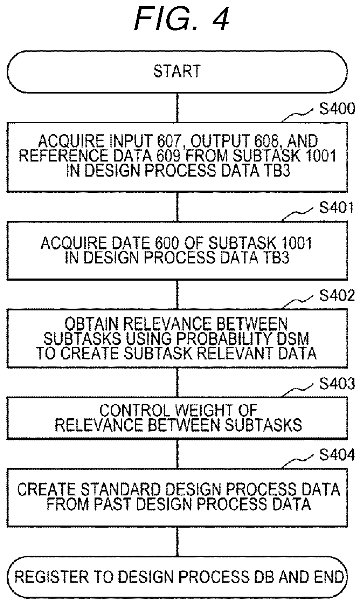

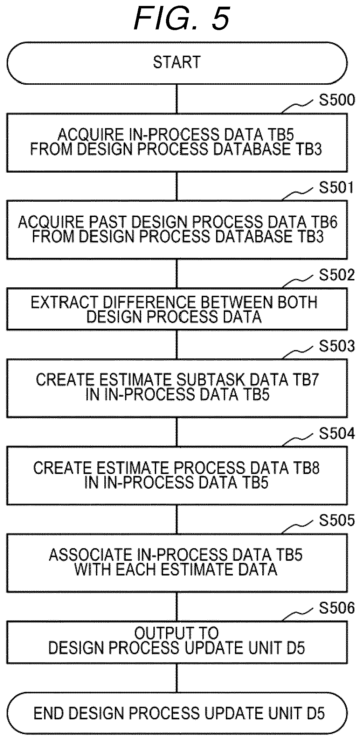

In addition, making a rough explanation on the functions of the design support device 1, the respective functions of a design history deriving procedure of which details are illustrated in FIG. 2, a subtask defining procedure of which details are illustrated in FIG. 3, a subtask relevance deriving procedure of which details are illustrated in FIG. 4, a design history deriving procedure of which details are illustrated in FIG. 5, a subtask defining procedure of which details are illustrated in FIG. 3, and a design process update procedure are performed sequentially.

Hereinafter, an outline of main functions in the processing procedure according to the invention will be described. The main functions will be described using the recording unit M and the processing unit D. Further, the processing unit D corresponds to a task relevance extraction unit D1, a subtask definition unit D2, a subtask relevance extraction unit D3, a difference extraction unit D4, and a design process update unit D5.

### (1) Recording Unit M

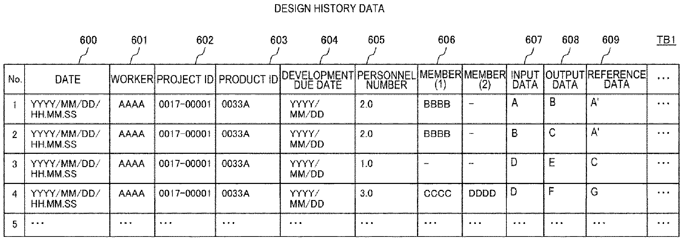

The recording unit M includes a unit which automatically stores an operation history produced in the calculator CPU by one or more operators as design history data TB1. Information of the operation history can be stored at any time as information such as a connection state, an operating software, and a stored and created file, for example, from a virtual design work environment provided on a cloud to a network. Specific storing contents include, as described below using FIG. 6, for example, information such as a file name and a creation date related to a file created or referred by the operator, a directory name and a creation date where a work is performed, and a worker. Herein, the information is stored on an assumption that the operation such as inputting/outputting or referring of a file is performed by an operator to proceed to a design.

Further, the recording unit M is stored with past data of a complete design project which has been already executed in the past by the operator and temporary data of an incomplete design project which is currently executed by the operator. In the invention, a design project not yet started or an incomplete design project which has been partially executed are subjected to a design support from the subsequent design procedure.

### (2) Task Relevance Extraction Unit D1

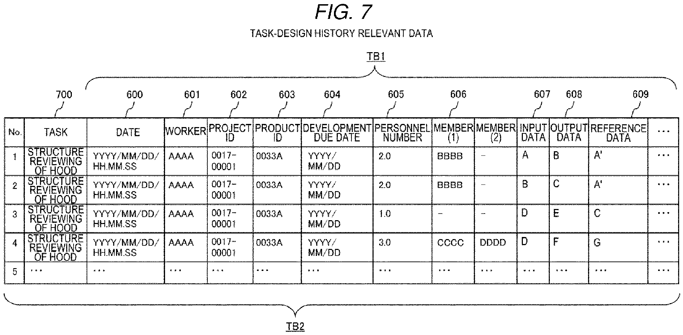

The task relevance extraction unit D1 is a unit which compares date information in the design history data TB1 with date information of a task in a design procedure table of each product or project of the operator, creates task-design history relevant data TB2 associating the design history data and the task, and stores the data to a design history database DB1. With this configuration, the design history data TB1 stored in the design procedure table during a task progressing period is highly related to the task, and becomes the task-design history relevant data TB2. As information which can be compared other than the date information, an input/output file, a reference file, and a work person can be compared for example. The task-design history relevant data TB2 will be described below using FIG. 7.

### (3) Subtask Definition Unit D2

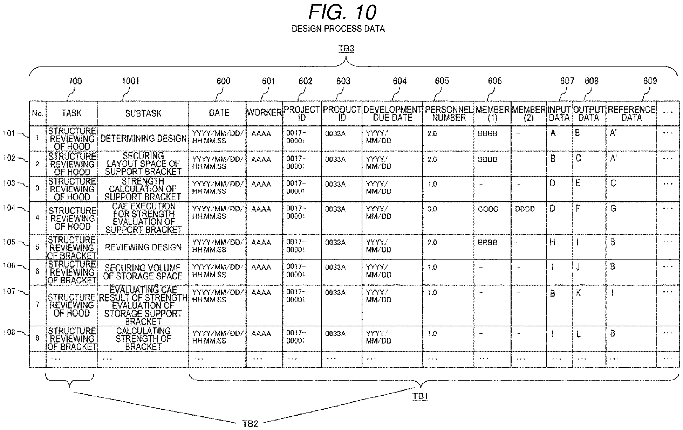

The subtask definition unit D2 is a unit which defines a subtask obtained by further dividing the task in the design procedure table from the design history data TB1 on the basis of the task-design history relevant data TB2. The subtask may be defined by dividing, for example, a unit of creation file and a unit of working directory stored in the design history data. The defined subtasks are sorted in an execution order, and registered to the design process database DB2 as design process data TB3 in association with the execution order between the subtasks. The design process data TB3 will be described below using FIG. 10.

Further, the design history data TB1 includes information of the working directory and the work person in addition to input/output information and reference information associated with, for example, a storing history of an input/output file and a reference history of a file. Therefore, when a subtask is defined, the information of the working directory and the work person can be defined as attribute information in association with the subtask in addition to the input/output file and the reference file. In addition, candidates of a subtask name are automatically presented to the operator from file names of the input/output file and the reference file, a title denoted in a file, or a folder name of the working directory, so that the operator is urged to define the subtask.

### (4) Subtask Relevance Extraction Unit D3

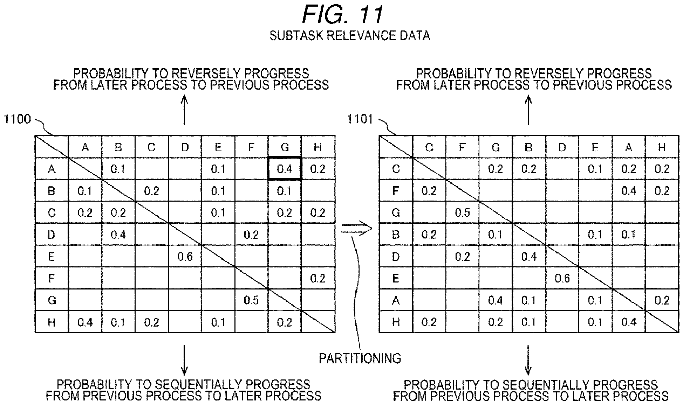

The subtask relevance extraction unit D3 includes a unit which calculates a relevance between the attribute information and the execution order or a frequency of occurrence of the subtask using the attribute information of the input/output file and the reference file defined in association with the subtask in the subtask definition unit D2, and stores the relevance as subtask relevance data TB4 to the design process database DB2. The subtask relevance data TB4 will be described using FIG. 11.

Further, as a method of calculating the relevance, for example, a technique disclosed in "Identifying Controlling Features of Engineering Design Iteration" (Smith, R. P. and S. D. Eppinger, 1997) may be applied. These methods are techniques in which the relevance between the subtasks is optimized by calculating a repetition probability so as to make an optimal process . The relevance may be weighted with an index indicating a length in an execution time of the entire process. For example, it is assumed that the design process data TB3 is completed at a short execution time than other design process data. The subtask of the design process data TB3 is weighted in correspondence with the calculated relevance. Therefore, the control may be performed to contribute to the change to an optimal process.

### (5) Difference Extraction Unit D4

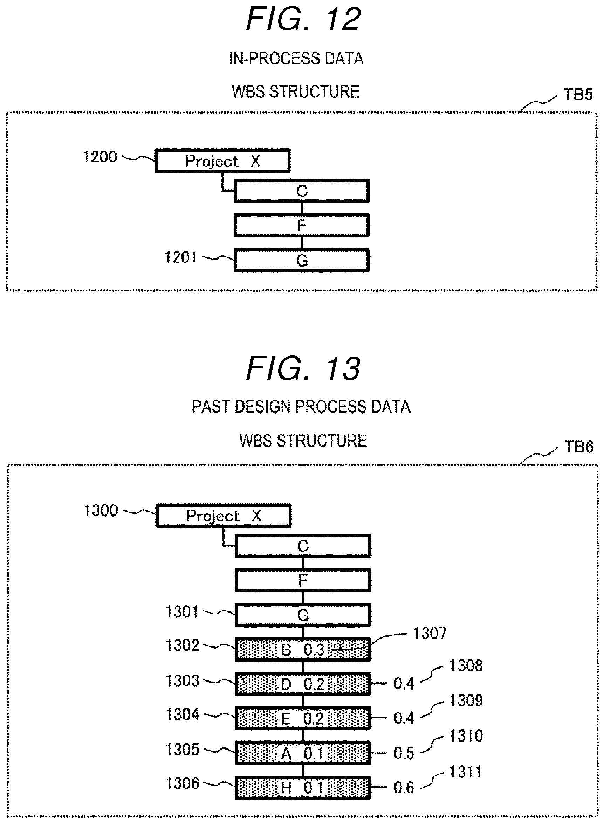

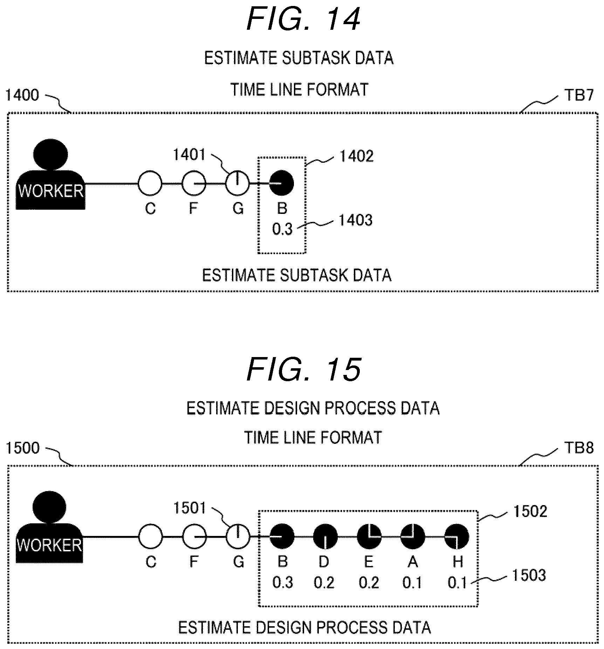

The difference extraction unit D4 includes a unit which compares in-process data TB5 registered to the design process data DB2 with the execution order or the relevance of the subtask of past design process data TB6, makes an estimation on the in-process data TB5 whether there is a subtask which is likely to occur in the subsequent calculation, and registers estimate subtask data TB7 to a design process update database D5 in association with the in-process data TB5. The in-process data TB5 and the past design process data TB6 will be described below using FIGS. 12 and 13. In addition, the estimate subtask data TB7 and the in-process data TB5 will be described below using FIGS. 14 and 15.

Further, the difference extraction unit D4 includes a unit which calculates an optimal execution order with respect to the in-process data TB5 on the basis of an average man-hour and the subtask relevance data TB4 with respect to the estimate subtask data TB7, and registers estimate design process data TB8 to the design process update unit D5 in association with the in-process data TB5. For example, in a case where the in-process data TB5 tends to increase more than the average man-hour, a process showing a tendency of a large average man-hour is retrieved from the design process database DB2. An optimal execution order is calculated on the basis of the similar past design process data TB6 and the subtask relevance data TB4 of the subtask thereof from the retrieval result.

### (6) Design Process Update Unit D5

In the design process update unit D5, the finally obtained processing result of the design support device 1 is displayed in the display unit of the calculator that the operator operates.

The outline of the invention has been described on the basis of the main functions of FIG. 1. Subsequently, the description will be given about examples of a specific processing procedure and a data flow of the device of the invention using FIGS. 2 to 6.

First, the description will be given using FIG. 2 about an example of a registration procedure from the recording unit M to the design history database DB1 which is executed by the task relevance extraction unit D1.

In the first Step S200 in the processing flow of FIG. 2, a design history of the operator is received by the recording unit M. The design history includes a history of operations performed by the operator. The design history is automatically recorded when the operator progresses the design work while appropriately changing in a time series. However, the recording may be updated by the recording unit M by a designer's own initiative.

Next, in Step S201, it is detected whether there is a new design history recorded by the recording unit M. In a case where there is no detection, the process returns to Step S200 to receive the design history.

In a case where a design history is detected in Step S201, the design history data TB1 is created on the basis of a content of the design history in Step S202.

FIG. 6 illustrates a specific content of the design history data TB1. The design history data TB1 of FIG. 6 is data of a table format of an XML format which includes a date 600, a worker 601, a project ID 602, a product ID 603, a development due date 604, a personnel number 605, a member name 606, input data 607, output data 608, and reference data 609. The design history data TB1 is automatically created on the basis of the design history from the recording unit M, and may be added or corrected on a designer's own initiative.

According to the design history of FIG. 6, "AAAA" who is an operator in charge of a project "0017-00001" meets coworkers "BBBB" and "CCCC", and working hours, reference data, input data, and output data are reviewed in association together. Further, the data is reviewed in units of appropriate time and organized even though the operator "AAAA" does not care in particular.

In Step S203, the date information of the task in the design procedure table of a project and a product of which the operator is in charge is acquired.

In a method of acquiring the date information, for example, when a keyword such as a project name and a product name included in a creation file of the design history data TB1 is retrieved, the attribute information such as the creation date and the work person is narrowed down in a hit file to select the design procedure table. The date information is acquired on the basis of the contents. Even in a case where a design process table is not yet established, the date is acquired on the basis of a file in which a Gantt chart and a due data are indicated to acquire the date information such as a task due date. Further, this device can normally operate even under an environment where the date information of the task is not possible to be normally acquired.

In Step S204, the date information acquired in Steps S202 and S203 are compared, and the design history data TB1 created during the task progressing period is retrieved and acquired.

In Step S205, the design history data TB1 created during the task progressing period and the task as a result of Step S204 are associated and registered to the design history database DB1 as the task-design history relevant data TB2. The registered task-design history relevant data TB2 is registered in a data format such as a table structure or an XML structure.

FIG. 7 illustrates an example of the task-design history relevant data TB2. In the example, a task 700 is newly added to the history data of the design history data TB1 of FIG. 6. According to FIG. 7, it can be seen that the work person "AAAA" in charge of the project "0017-00001" performs "structure reviewing of hood" as a task.

Further, in the invention, a plurality of tasks are executed to achieve a project, or each task is formed by a plurality of subtasks.

Next, an example of a registration procedure from the subtask definition unit D2 to the design process database DB2 will be described using FIG. 3.

In the first Step S300 of the processing flow of FIG. 3, a change from a time point when the previous subtask is defined is received from the design history database DB1. An occurrence or a section of the subtask is detected as follows.

For example, when an arbitrary file is generated, it is detected that one or more arbitrary files are generated or one subtask is generated by grasping a copying action on the basis of a difference of the design history data TB1 before and after the file generation, or it is detected that a subtask is terminated. A threshold value used in the detection is set by the operator such that the subtask is finely or roughly graded.

Next, in Step S301, it is detected whether there is a new design history. In a case where there is no detection on the basis of a change at the time of defining the previous subtask, a change is received again in Step S300.

In Step S302, a file name and a main topic of the content of the generated file is acquired in the detected design history data TB1 in Step S300. In this case, while the process is specified to a file, the working directory or a folder name included in the design history data TB 1 may be acquired.

In Step S303, the subtask is defined using the acquired file name and the acquired subtask name as candidates. At this time, the subtask name may be arbitrarily corrected or changed by the operator. In the definition of these subtasks, there are included the date, a task name, the worker, the project ID, a product name, an examination item, the input data, the output data, the reference data, the development due date, a scale, the personnel number, and the member name. Further, these types of information are defined in association with all the subtasks.

In Step S304, the subtask defined in Step S303, the task name, and the worker are registered to the design process database DB2 as the design process data TB3.

FIG. 10 illustrates an example of the design process data TB3 which is generated from the subtask definition unit D2. According to the drawing, the design process data TB3 is data obtained by adding a subtask 1001 to the task-design history relevant data TB2. Herein, there is illustrated an example where a structure reviewing is progressed on a hood and a luggage floor included in a vehicle body.

Making an explanation on a task "structure reviewing of hood" for example, the subtasks in this case include "determine design" in design process data 101, "secure layout space of support bracket" in design process data 102, "calculate strength of support bracket" in design process data 103, "execute CAE for strength evaluation of support bracket" in design process data 104, and "evaluate CAE result for strength evaluation of support bracket" in design process data 107. In addition, making an explanation on a task "structure reviewing of bracket" for example, the subtasks include "determine design" in design process data 105, "secure volume of storage space" in design process data 106, "calculate strength of bracket" in design process data 108.

According to a processing history performed by the operator "AAAA", it can be seen that the design process data 101 to 104 corresponds to the structure reviewing of the hood, the structure reviewing is performed over the design process data 105 and 106, the structure reviewing of the hood is performed in the design process data 107, and the structure reviewing of the bracket restarts from the design process data 108.

In the flow of FIG. 3, the subtask name is automatically set. However, considering ease of use after the determination work, it is more comfortable for the operator to artificially set the subtask name. Therefore, there may be employed a registering method in which the operator registers the subtask name proposed by the design support device 1 after confirming using a monitor screen of the calculator CPU.

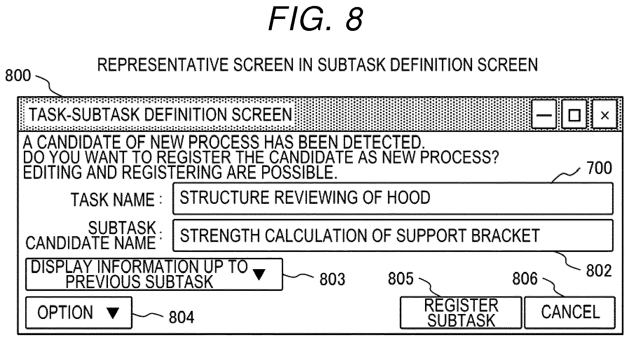

FIG. 8 illustrates an example of a subtask definition screen as a monitor screen of the calculator CPU. In a subtask definition screen 800, the task name 700 previously extracted from the task-design history relevant data TB2 and a subtask candidate 802 extracted by the design support device 1 from a file of the design history data are displayed to the operator. In addition, a subtask registration menu 805 and a cancel menu 806 are set on the screen 800 to register and cancel a subtask. The operator defines a subtask while confirming the content of the subtask definition screen, and may edit or add a note.

In addition, there are provided a menu 803 which presents information of a subtask performed until right before on the same task, and an option menu 804 which presents information related to the subtask. These menus 803 and 804 are used for the design support device 1 to extract the subtask candidate 802 to specifically show proposed basis data to the operator in order to easily get confirmation and understanding of the operator. The basis data indicates information related to the defining of a subtask and information used as a basis for the defining.

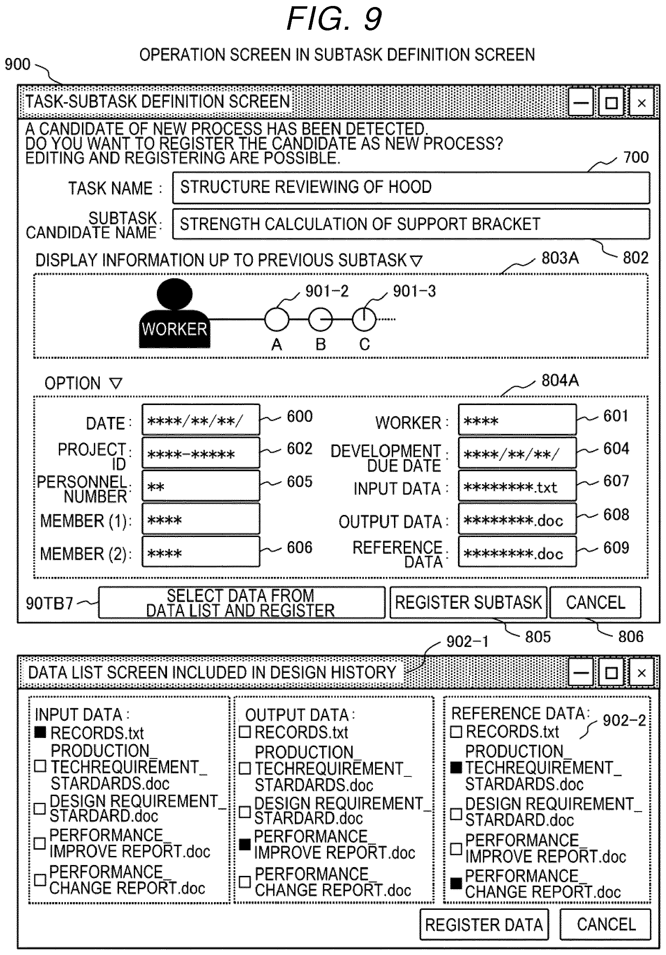

FIG. 9 illustrates an exemplary screen which displays the basis data of a subtask proposal. In a basis data display screen 900, there are displayed the menu 803 indicating the information until the previous subtask, and exemplary expansion screens 803A and 804A when the option menu 804 is selected.

First, the description will be given about the exemplary expansion screen 803A of the menu 803 which displays the information until the previous subtask. Herein, the subtasks in a task which has been performed by the work person are displayed in a time series. In this example, a subtask A performed at first in the task corresponds to a left end 901-2, and an in-process subtask C corresponds to a right end 901-3. In this way, a plotting of connecting the subtasks in a time series in an execution order is called a time line hereinbelow. The time line may be presented to the operator using unique symbols together with the subtask names. In a case where there are several work persons of the subtask, the subtask may also be displayed with a connection to the work persons.

Next, the description will be given about the exemplary expansion screen 804A of the option menu 804. Herein, the recorded content of the design history data TB1 is displayed as information to help the operator confirm. There are displayed the date 600, the worker 601, the project ID 602, the development due date 604, the personnel number 605, the member name 606, the input data 607, the output data 608, and the reference data 609 in the subtask.

Further, the input data, the output data, and the reference data may be selected from a data list screen 902-1 included in the design history data TB1 by individually selecting data from the data list 902-1 and selecting a registration button 90TB7 in a case where the option 804A is displayed. For example, a plurality of pieces of the corresponding data may be selected as the reference data 609.

Using the screens described in FIGS. 8 and 9, the design process data TB3 of FIG. 10 is generated, confirmed, and completed. However, the design process data TB3 is data arranged for each task and each subtask related to the task on the basis of the definition result of the subtask. In other words, the design process data of each row and column is registered in association with the subtask 1001 related to the task 700. In addition, since the subtask is defined according to the design history performed by the operator, the task and the subtask are registered according to the execution order of the operator.

Next, the description will be given about an example of a registration procedure from the subtask relevance extraction unit D3 to the design process DB DB2 using FIG. 4.

In the first Step S400 of a process of extracting a relevance of the subtask, the input data 607, the output data 608, and the reference data 609 which are associated with the subtask 1001 are acquired in the design process data TB3 of the defined subtask.

Next, in Step S401, the date 600 in the subtask 1001 is acquired in the design process data TB3 of the defined subtask.

In Step S402, a relevance between subtasks is calculated from the acquisition result in Step S400 and the execution order of the subtask 1001 obtained from the acquisition result of Step S401, and the subtask relevance data TB4 is created. As a method of calculating a relevance, for example, there may be applied a technique disclosed in "Identifying Controlling Features of Engineering Design Iteration" (Smith, R. P. and S. D. Eppinger, 1997) . These methods are techniques in which the relevance between the subtasks is optimized by calculating an elapsed time of the subtask and the repetition probability so as to make an optimal process. With this technique, the relevance between the subtasks is quantitatively evaluated, and the correction of an optimal process can be achieved.

In Step S403 which is additionally performed as needed, the relevance obtained in Step S402 may be assigned with a weight using indexes such as the length of execution time of the entire process, a design skill of the operator, and the number of skipped subtasks. For example, it is assumed that there is a design process data which is completed in a state where the execution time is shorter than other design process data, and the number of skipped subtasks is small. In this case, the weight of the relevance is set to be high in the subtask of the design process data so as to perform the control to contribute to the change to an optimal process. Step S403 may be appropriately performed as needed.

In Step S404, highly versatile and standard design process data is generated from a design process data group which has been performed in the past as the operation is progressed. Such data is called standard design process data.

FIG. 11 illustrates an example of the subtask relevance data TB4 which is generated from the subtask relevance extraction unit D3. The subtask relevance data TB4 of FIG. 11 is arranged on a matrix which contains the subtasks (denoted by A to H) lengthwise and breadthwise. Relevances 1100 and 1101 are obtained by calculating the relevances between the subtasks from the input/output in the subtasks, the reference data, and the execution order of the subtasks, and by arranging the relevances in a matrix shape as the subtask relevance data TB3.

As a method of calculating the relevance, for example, a technique disclosed in "Identifying Controlling Features of Engineering Design Iteration" (Smith, R. P. and S. D. Eppinger, 1997) is applied. A DSM (Design Structure Matrix) used in the technique is a method of calculating an elapsed time of the subtask and the repetition probability so as to change the relevance between the subtasks to an optimal process.

FIG. 11 illustrates an example of a result of establishing the DSM according to the execution order of the actual subtasks (A to H) with respect to the design process data (101 to 108) of FIG. 10. In the example of FIG. 11, in a case where the subtasks A to H are provided, the numbers below the diagonal in the matrixes 1100 and 1101 of the relevances show probabilities that the subtasks are sequentially progressed from the previous process to the later process. On the other hand, the numbers above the diagonal show probabilities that the subtasks are progressed reversely from the later process to the previous process . Further, the number surrounded by "O" above the diagonal shows an elapsed time of the subtask, and is calculated from the date between the subtasks.

The matrix 1100 of the relevance of FIG. 11 shows the relevance in a case where the subtasks are progressed in a longitudinal direction. For example, in a case where the subtasks are sequentially progressed from A to G, the next one to be actually processed is the subtask H. However, a probability to return to the task A is 0.4 which is significantly high. In addition, the other portions to be likely to return to the previous process are also denoted with probability values.

Therefore, in the invention, the execution order of the subtasks having a low probability to return to the previous process is reviewed. The matrix 1101 of the relevance of FIG. 11 shows an example of a result obtained when the DSM is used to perform partitioning on the matrix 1000 before correction to sequence the subtasks. The partitioning is an analysis technique to optimize the process. For example, the probabilities indicating a dependent relation between the subtasks are moved down below the diagonal by changing the order of rows and columns of the DSM. Therefore, it is possible to remove a loop that the subtask is reversely progressed from the later process to the previous process. In other words, the process is reduced in reworking and correcting, and thus is optimized. In an actual DSM, it is not possible to move down all the probabilities below the diagonal. In that case, the probabilities are arranged above the diagonal as many as possible to easily perform the subtasks repeatedly by linking the subtasks. Therefore, it is possible to finish the cycle in a short period of time.

According to the matrix 1101 of the relevance after correction, the subtasks are not performed in an order of A → B → C → D → E → F → G, but in an order of C → F → G → B → D → E → A → H.

Next, the description will be given about an example of a procedure after the process of the difference extraction unit D4 up to the design process update unit D5 in FIG. 5 using the in-process data TB5 and the past design process data TB6 obtained from the design process database DB2.

In the first Step S500 in the processing flow of FIG. 5, the in-process data TB5 created in an in-process design work is acquired from the design process data TB3.

Next, in Step S501, the registered past design process data TB6 is acquired from the design process data TB3. The past design process TB6 is a synonym for the standard design process data. In other words, in the case of the same type of design performed in the past, the execution order of the subtasks at that time is corrected to an execution order of the subtasks after the partitioning using the DSM described above, and then recorded as the past design process TB6. With this configuration, the past design process TB6 can be handled as the standard design process data, and can be handled as training data with respect to the in-process data TB5 described below.

In Step S502, the in-process data TB5 and the past design process data TB6 are compared to extract a difference. Specifically, the subtasks of both the design process data TB5 and TB6 are compared, and a difference from the past design process data TB6 in the in-process data TB5 is extracted.

In Step S503, a subtask to be executed next in the in-process data TB5 is created as the estimate subtask data TB7 from the difference data extracted in Step S502.

In Step S504, a design process data to be executed future in the in-process data TB5 is created as the estimate design process TB8 from the difference data extracted in Step S502.

In Step S505, the estimate subtask data TB7 created in Step S503 and the estimate process data TB8 created in Step S504 are associated to the in-process data TB5.

In Step S506, the in-process data TB5 associated to Step S505 is output to the design process update unit D5. In the design process update unit D5, the subtask to be executed later is displayed in an output device for the operator to confirm.

Next, the description will be given using a WBS (Work Breakdown Structure) 1200 about an example of the in-process data TB5 registered in the design process data TB3 with reference to FIG. 12.

In FIG. 12, the WBS is illustrated in which the subtasks of the in-process data TB5 is displayed in a tree structure in the execution order from up to down. In an uppermost tree 1200, the project ID or the product ID is positioned, but the task may be positioned. Herein, three subtasks of the executed subtasks C and F and an in-process subtask G (1201) are positioned in the lower hierarchies from the uppermost hierarchy.

Next, the description will be given using a WBS 1300 about an example of the past design process data TB6 registered in the design process data TB3 with reference to FIG. 13. Herein, subtasks B (1301) to H (1306) to be executed later are displayed according to the content of an in-process subtask G (1301) in the in-process data TB5.

In each subtask, the dependent relation to the subtask G (1301) is associated. For example, the subtask B (1302) is associated to a value of 0.3 which is displayed as a probability 1307 to return to the previous process after executing the subtask G (1301). Similarly to 1307, the dependent relation is associated even to the subsequent subtasks.

Since the calculation is made according to the in-process subtask, the probability is sequentially calculated according to a progress situation of the subtasks, so that the design process data TB3 optimized to the situation in progressing of the operator is displayed. Further, the dependent relation to the subtasks of the previous process is also associated to subtasks D (1303) to H (1306) after executing the subtask B (1301). For example, a probability 1308 that the subtask D (1303) is executed next to the subtask B (1302) of the previous process is associated with a value of 0.4.

Next, the description will be given in a time line format 1400 about an example of the estimate subtask data TB7 which is generated from the difference extraction unit D4 with reference to FIG. 14. The estimate subtask data TB7 is a subtask to be executed next in an in-process subtask G (1401) . Herein, a subtask B (1402) corresponds to the estimate subtask data. Further, in a case where the estimate subtask data is displayed in the time line format, the estimate subtask data 1402 is highlighted. A probability 1403 that is a dependent relation to the subtask G (1401) of the previous process may also be displayed.

Next, the description will be given in a time line format 1500 about an example of the estimate design process data TB8 which is generated from the difference extraction unit D4 with reference to FIG. 15. The estimate design process data TB8 is a subtask group to be executed later in an in-process subtask 1501. In other words, the estimate design process data is a process to be executed later. Herein, a subtask group 1502 corresponds to the estimate design process data. Further, in a case where the estimate design process data is displayed in the time line format, the estimate design process data 1502 is highlighted. A probability 1503 that is a dependent relation to the in-process subtask G (1501) may also be displayed.

Finally, the description will be given about a time line format 1600 and a WBS structure 1601 as an example of data to be output from the design process update unit D5 to an output device.

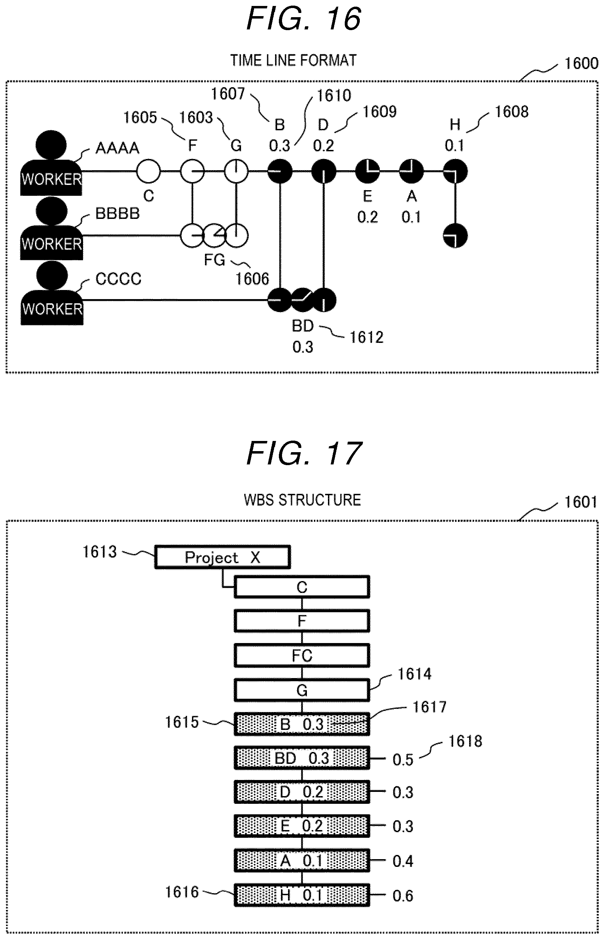

First, the output data of the time line format 1600 will be described using FIG. 16. Herein, when the operator is denoted as a work person AAAA, it is assumed that the work person AAAA performs an in-process subtask G (1603) jointly with a work person BBBB. It can be seen from the time line that the work person BBBB performs a subtask F (1605) jointly with the work person AAAA just before, and the subsequent subtask FG (1606) is performed only by the work person BBBB. A subtask H (1608) is output from a subtask B (1607) to be performed in the later process of the subsequent subtask G (1603), and may also be highlighted. For example, the subtask B (1607) and a subtask D (1609) are necessarily performed jointly with a work person CCCC. Further, it can be seen that a subtask BD (1612) which is the later process of the subtask B (1607) is performed only by the work person CCCC. In addition, a probability 1610 which is a dependent relation to the subtask G (1603) may be displayed in each subtask. For example, it can be seen that a probability that the subtask B (1607) is performed as the later process of the subtask G (1603) is 0.3.

Next, the output data of the WBS structure 1601 will be described using FIG. 17. The output data is output in a tree structure on the execution order of the subtasks in the time line format. In the uppermost hierarchy 1613, the project ID or the product ID is positioned, but a task may also be positioned. Herein, it is assumed that the operator performs a task G (1614) as an in-process subtask. Subtasks B (1615) to H (1616) to be performed in the later process are output, and may also be highlighted. In addition, a probability 1617 which is a dependent relation to the subtask G (1614) may be displayed in each subtask. For example, it can be seen that a probability 1617 that the subtask B (1615) is performed as the later process of the subtask G (1614) is 0.3. In addition, a probability 1618 that is a dependent relation to the previous process may also be displayed in the subsequent subtask B (1615) . For example, it can be seen that a probability 1618 that a subtask BD is performed as the later process of the subtask B (1615) is 0.5, and the dependent relation between the subtask B and the subtask BD is high. In addition, a strength of the dependent relation displayed in the time line format and the WBS structure may be displayed by a thickness of line indicating a connection between the subtasks or a density of highlight color for example. As described above, the output data has been described using the time line format and the WBS structure as a representative example, and besides may be output in a table structure or an XML format.

The design support device according to the embodiment of the invention described above employs the following configuration for example. The design support device includes the recording unit M which stores the operation history of a design tool operated by the operator and a history of creating/referring a file as the design history data TB1, the task relevance extraction unit D1 which compares the date information in the design history data TB1 with the date information of a task in the design procedure table of each product or project, and associates and registers the task and the design history data TB1 as the task-design history relevant data TB2 to the design history database DB1, the subtask definition unit D2 which divides the design history data TB1 in a unit of subtask on the basis of the task-design history relevant data TB2, associates and registers the subtasks and the execution order of the subtasks in the design process database DB2 as the design process data TB3, the subtask relevance extraction unit D3 which calculates a relevance of the subtask from a relation between a creation file and a reference file in the subtask and a relation between the subtask and the execution order and registers the relevance to the design process database DB2 as the subtask relevance data TB4, the difference extraction unit D4 which sets the created design process data TB3 as the in-process data TB5 for the in-process design work, sets the design process data TB3 registered to the design process database DB2 as the past design process data TB6, compares the in-process data TB5 with the past design process data TB6, estimates a subtask to be performed in the subsequent design work with respect to the in-process design work, registers the estimate subtask to the design process update database D5 as the estimate subtask data TB7, calculates an optimal execution order on the basis of the average man-hour of the estimate subtask data TB7 and the subtask relevance data TB4, and registers the optimal execution order to the design process update database D5 as the estimate design process data TB8, and an output unit which outputs the estimate subtask data TB7 and the estimate design process data TB8 to a display unit through an output device CPU.

## Claims

1. A design support device (1) which supports a design project achieved by executing a plurality of tasks where one or a plurality of subtasks are included, the design support device (1) including:
- a recording unit (M) which sequentially stores design history data (TB1) of a design performed by a designer using a calculator (CPU),
- an output unit which outputs design support information, and
- a calculation unit (D), the calculation unit (D) including:
- a task relevance extraction unit (D1) which associates the design history data (TB1) with the task to sequentially generate task-design history relevant data (TB2);
- a subtask definition unit (D2) which defines the subtask with respect to the task-design history relevant data (TB2) to sequentially generate design process data (TB3);
- a subtask relevance extraction unit (D3) which generates subtask relevant data indicating a relevance between subtasks with respect to the plurality of pieces of design process data; and
- a difference extraction unit (D4) which estimates a subtask to be performed in a later design work with respect to an in-process design work from a difference between past design process data (TB6) of a project performed in the past and in-process data (TB5) in a project performed currently to obtain an estimate subtask, and calculates an optimal execution order to obtain estimate design process data (TB8), and the estimate design process data (TB8) being output through the output unit.

2. The design support device (1) according to claim 1, wherein
the design history data (TB1) is obtained by recording an operation history of the calculator (CPU) which is a design tool and a history of creating/referring a file.

3. The design support device (1) according to claim 1 or 2, wherein
the task relevance extraction unit (D1) compares date information in the design history data (TB1) with date information of a task in a design procedure table of each product or project, and associates and generates the task and the design history data (TB1) as task-design history relevant data (TB2).

4. The design support device (1) according to any one of claims 1 to 3, wherein
the subtask definition unit (D2) divides the design history data (TB1) in a unit of subtask on the basis of the task-design history relevant data (TB2), and obtains the subtasks and an execution order of the subtasks as the design process data.

5. The design support device (1) according to any one of claims 1 to 4, wherein
the subtask relevance extraction unit (D1) calculates a relevance of the subtask from a relation of an execution order of the subtasks in the design process data, and obtains the relevance as the subtask relevance data (TB4).

6. The design support device (1) according to any one of claims 1 to 5, wherein
the difference extraction unit calculates an optimal execution order on the basis of an average manhour and subtask relevance data (TB4) of the estimate subtask, and obtains the optimal execution order as an estimate design process.

7. The design support device (1) according to any one of claims 1 to 6, wherein
the subtask definition unit (D2) displays a subtask generation screen in a monitor of the calculator (CPU), proposes a subtask name of an in-process task and a naming basis, and employs a subtask name which is set by an operator of the calculator (CPU).

8. The design support device (1) according to any one of claims 1 to 7, wherein
the difference extraction unit displays the estimate subtask in a monitor of the calculator (CPU) as a display screen of a time line format or a WBS structure.

9. A design support device (1) which supports a design project achieved by executing a plurality of tasks where one or a plurality of subtasks are included, the design support device comprising:
- a unit which stores the operation history of a design tool operated by an operator and a history of creating/referring a file as design history data (TB1);
- a unit which compares date information in the design history data (TB1) with date information of a task in a design procedure table of each product or project, and associates and registers the task and the design history data (TB1) as task-design history relevant data (TB2) to a design history database;
- a unit which divides the design history data (TB1) in a unit of subtask on the basis of the task-design history relevant data (TB2), and associates and registers the subtasks and an execution order of the subtasks in a design process database (DB2) as design process data;
- a unit which calculates a relevance of the subtask from a relation between a creation file and a reference file in the subtask and a relation between the subtask
and the execution order and registers the relevance to the design process database (DB2) as subtask relevance data (TB4);
- a unit (D4) which sets the created design process data (TB3) as in-process data (TB5) for an in-process design work, sets the design process data (TB3) registered to the design process database (DB2) as past design process data (TB6), compares the in process data with the past design process data (TB6), estimates a subtask to be performed in a subsequent design work with respect to the in-process design work, registers the estimate subtask as the estimate subtask data (TB7) ;
- a unit which calculates an optimal execution order on the basis of an average man-hour of the estimate subtask and the subtask relevance data (TB4), and registers the optimal execution order as an estimate design process; and
- a unit which (D5) displays the estimate design process through an output device.

10. A design support method which supports a design project achieved by executing a plurality of tasks where one or a plurality of subtasks are included, comprising:
- storing sequentially design history data (TB1) of a design performed by a designer using a calculator (CPU);
- associating the design history data (TB1) with the task to sequentially generate task-design history relevant data (TB2);
- defining a subtask with respect to the task-design history relevant data (TB2) to sequentially generate design process data (TB3);
- generating subtask relevance data (TB4) which indicates a relevance between the subtasks with respect to the plurality of pieces of design process data;
- estimating a subtask to be performed in a later design work with respect to an in-progress design work from a difference between past design process data (TB6) of a project performed in a past and in-process data (TB5) in a project performed currently to obtain an estimate subtask; and
- presenting estimate design process data (TB8) of which an optimal execution order is calculated to the designer as the estimate subtask.

11. A design support method which supports an operator to perform a design project using a calculator (CPU), the project being achieved by executing a plurality of tasks where one or a plurality of subtasks are included, comprising:
- analyzing a design history of the operator from the calculator (CPU) in a unit of subtask by comparing the history with a design procedure table;
- calculating a relevance between subtasks from a relation between a creation file associated with the subtask and a reference file;
- extracting an optimal design process from the relevance; and
- presenting the optimal design process to the operator.
